# EUROPÄISCHE PATENTANMELDUNG

(11) **EP 1 814 168 A1**
(43) Veröffentlichungstag der Anmeldung: **01.08.2007**
(21) Anmeldenummer: 06124979.3
(22) Anmeldetag: 29.11.2006
(51) Int. Cl.: H01L 41/083, H02N 2/06, F02M 51/06, F16K 31/00, B60T 8/36

(54) **Piezoelektrischer Aktor mit integriertem piezoelektrischen Transformator**

(30) Priorität: 31.01.2006 DE 102006004289
(71) Anmelder: ROBERT BOSCH GMBH, 70442 Stuttgart (DE)
(72) Erfinder: Kelnberger, Alfons, 96047, Bamberg (DE)

(57) **Zusammenfassung**

Es wird eine Kombination aus piezoelektrischen Aktor (1) und piezoelektrischem Transformator (17) vorgeschlagen. Dadurch ist es möglich, bei gleichbleibenden Eingangsspannungen an den Anschlüssen (13) und (15) des piezoelektrischen Aktors den Aufbau des piezoelektrischen Aktors (1) deutlich zu vereinfachen.

## Beschreibung

### Stand der Technik

### Beschreibung

Piezokeramische Bauelemente gewinnen zunehmend an Bedeutung in automobilen Anwendungen, insbesondere als Aktoren bspw. von Injektoren einer Kraftstoffeinspritzanlage oder in Druckregelventilen von Fahrstabilitätssystemen, wie ABS, ARS und anderem mehr.

Bei den als Aktoren eingesetzten piezokeramischen Bauelementen nutzt man den sogenannten indirekten Piezoeffekt, der es ermöglicht, elektrische Energie in mechanische Energie umzusetzen. Bei den bereits in Serie gefertigten Piezoinjektoren werden piezokeramische Vielschichtaktoren mit einer elektrischen Spannung zwischen 100 Volt und 200 Volt beaufschlagt, was je nach Länge des Aktors eine Dehnung in der Größenordnung von 30.µm bis 70. µm verursacht. Durch diese Dehnung des Piezoaktors wird ein Stellglied eines Ventils betätigt. Über einen hydraulischen Koppler wird mit Hilfe dieses Ventils eine Düsennadel des Injektors geöffnet oder geschlossen und in Folge dessen Kraftstoff unter hohem Druck in den Brennraum eingespritzt.

Die Dehnung des piezokeramischen Materials hängt von der Feldstärke des im Piezoaktor herrschenden elektrischen Felds (E = U/d) ab. Elektrische Felder in der Größenordnung von 2 Kilovolt/Millimeter erzeugen eine für praktische Anwendungen ausreichend hohe Dehnung. Da in Steuergeräten mit herkömmlichen elektronischen Bauteilen elektrische Spannungen von bis zu etwa 200 Volt relativ kostengünstig realisiert werden können, müssen die Schichtdicken der verschiedenen Schichten innerhalb des Piezoaktors in einem Bereich zwischen 60 µm und 100 µm liegen.

Da die Herstellungskosten und das Fehlerrisiko mit der Zahl der Schichten in einem Piezoaktor ansteigen, ist man grundsätzlich bestrebt die Schichtdicke so groß wie möglich zu machen.

Der Erfindung liegt die Aufgabe zugrunde, einen piezoelektrischen Aktor bereit zustellen, der einfacher und kostengünstiger herzustellen ist und der von einem herkömmlichen Steuergerät mit einer Ausgangsspannung von etwa 200 Volt angesteuert werden kann.

### Offenbarung der Erfindung

Diese Aufgabe wird erfindungsgemäß bei einem piezoelektrischem Aktor mit mehreren übereinander angeordneten Keramikschichten, mit einem ersten elektrischen Anschluss, und mit einem zweiten elektrischen Anschluss, wobei zwischen den Keramikschichten jeweils eine Elektrodenschicht vorgesehen ist, wobei eine erste Gruppe von Elektrodenschichten elektrisch mit dem ersten Anschluss verbunden und wobei eine zweite Gruppe von Elektrodenschichten elektrisch mit dem zweiten Anschluss verbunden ist, dadurch gelöst, dass zwischen erstem elektrischen Anschluss und zweitem elektrischen Anschluss einerseits und den Elektrodenschichten andererseits ein piezoelektrischer Transformator vorgesehen ist.

### Vorteile der Erfindung

Durch die erfindungsgemäße Integration eines piezoelektrischen Transformators in den piezoelektrischem Aktor kann die Betriebsspannung des piezoelektrischen Aktor deutlich erhöht werden, ohne dass die Ausgangsspannung des Steuergeräts erhöht werden muss. Dies bedeutet, dass gleiche elektrische Feldstärke vorausgesetzt, der piezoelektrische Aktors aus dickeren Keramikschichten aufgebaut werden kann. Daraus ergeben sich drastische Kosteneinsparpotentiale, sowohl bei den Prozesskosten als auch bei den Materialkosten. Beispielsweise könnten erhebliche Kosten bei der Innenmetallisierungspaste eingespart werden. Die Innenmetallisierungspaste enthält üblicherweise das sehr teuere Metall Palladium. Aus diesem Grund wirkt sich die Einsparung von Innenmetallisierungspaste in nennenswertem Umfang auf die Produktionskosten aus.

Des weiteren wird der erfindungsgemäße piezoelektrische Aktor wegen der vergrößerten Dicke der Keramikschichten mechanisch robuster. Außerdem wird die Zahl der potentiellen Schwachstellen reduziert, da sich die Zahl der Grenzflächen zwischen Keramik und Elektroden bei gleicher Baulänge des piezoelektrischen Aktors reduziert.

Die gesteigerte Dicke der Keramikschichten eröffnet die Möglichkeit, andere Formgebungs- und Aufbauverfahren zu nutzen. Es wäre sogar denkbar, dass ein piezoelektrischer Aktor aus einzeln gepressten und gesinterten Keramikschichten aufgebaut wird, die vor oder nach dem Sintern kontaktiert und aufeinander geklebt werden. Dadurch kann das Foliengießen, wie es bei der Herstellung von Folien mit einer Dicke von weniger als 100 .µm heute üblich ist, vollständig entfallen.

Durch die direkte Kopplung der Hochspannungserzeugung mit dem piezoelektrischen Aktor wird zudem das Problem einer ausreichenden Kurzschlusssicherheit stark verringert. Es wäre beispielsweise denkbar, den piezoelektrischen Aktor zusammen mit dem piezoelektrischen Transformator mit einer elektrisch nichtleitenden Vergussmasse zu umgießen.

Vorteilhafter Weise könnte der piezoelektrische Transformator in einem Stecker integriert sein. Er könnte alternativ auch auf den piezoelektrischen Aktor aufgeklebt werden. Ganz besonders vorteilhaft wäre es, den piezoelektrischen Aktor und den piezoelektrischen Transformator in einem gemeinsam Sinterprozess herzustellen.

Wegen der größeren Schichtdicke verringert sich die Kapazität des piezoelektrischen Aktors signifikant, sodass die Lade- und Entladeströme verringert werden. Dies verbessert das Ansprechverhalten und den elektrischen Wirkungsgrad des piezoelektrischen Aktors.

In vorteilhafter Ausgestaltung der Erfindung ist vorgesehen, dass der piezoelektrische Transformator die elektrische Eingangsspannung (Uᵢ) mit einem Übersetzungsverhältnis (i) größer als 5, bevorzugt größer als 8 und besonders bevorzug etwa gleich 10 in eine elektrische Ausgangsspannung (Uₒ) übersetzt. Mit dieser elektrischen Ausgangsspannung (Uₒ) wird der piezoelektrische Aktor beaufschlagt. In erster Näherung ist die Schichtdicke der keramischen Schichten im piezoelektrischen Aktor proportional zur Eingangsspannung, so dass die Schichtdicke bis zum Faktor 10 erhöht werden kann und infolge dessen die Zahl der Keramikschichten bei gleicher Baulänge des piezoelektrische Aktors auf 1/10 reduziert werden kann.

In weiterer erfindungsgemäßer Ausgestaltung des piezoelektrischen Aktors ist vorgesehen, dass die erste Gruppe von Elektrodenschichten mit einer ersten Außenelektrode elektrisch verbunden ist, dass die zweite Gruppe von Elektrodenschichten mit einer zweiten Außenelektrode elektrisch verbunden ist, und dass die erste Außenelektrode und die zweite Außenelektrode elektrisch mit dem piezoelektrischen Transformator verbunden sind. Dadurch ist gewährleistet, dass der piezoelektrische Aktor mit der Ausgangsspannung Uₒ des piezoelektrischen Transformators versorgt wird.

In weiterer vorteilhafter Ausgestaltung der Erfindung sind der erste Anschluss und der zweite Anschluss des piezoelektrischen Aktors mit dem piezoelektrischen Transformator elektrisch verbunden. Dadurch ist es möglich, den piezoelektrischen Aktors mittels eines herkömmlichen Steuergerätes anzusteuern. Wegen des erfindungsgemäßen piezoelektrischen Transformators kann die Steuerspannung des Steuergeräts in einem Bereich von 100 bis 200 Volt liegen und gleichzeitig ist es möglich piezoelektrische Aktoren einzusetzen, deren Keramikschichten eine Dicke von bis zu einem Millimeter aufweisen.

Es hat sich weiter als vorteilhaft erwiesen, wenn der piezoelektrische Aktor und der piezoelektrische Transformator in einem Gehäuse angeordnet sind. Dadurch ergibt sich ein besonders robuster Piezoaktor und die Problematik der Isolierung gegen Kurzschlüsse im hochspannungsführenden Bereich wird entschärft.

Besonders bevorzugte Anwendungen des erfindungsgemäßen piezoelektrischen Aktors sind die sogenannten Piezoinjektoren von Kraftstoffeinspritzsystemen für Brennkraftmaschinen aber auch elektrisch betätigte Ventile, wie bspw. ein Druckregelventil für ein Antiblockiersystem oder ein anderes Fahrstabilitätssystem eines Kraftfahrzeugs.

Weitere Vorteile und vorteilhafte Ausgestaltungen der Erfindung sind der nachfolgenden Zeichnung, deren Beschreibung und den Patentansprüchen entnehmbar. Alle in der Zeichnung, deren Beschreibung und den Patentansprüchen offenbarten Merkmale können sowohl einzeln als auch in beliebiger Kombination miteinander erfindungswesentlich sein.

### Zeichnung

Es zeigen:
Figur 1 eine schematisch Darstellung eines erfindungsgemäßen piezoelektrischen Aktors und
Figur 2 eine schematische Darstellung eines in einen Injektor integrierten erfindungsgemäßen piezoelektrischen Aktors.

### Beschreibung der Ausführungsbeispiele

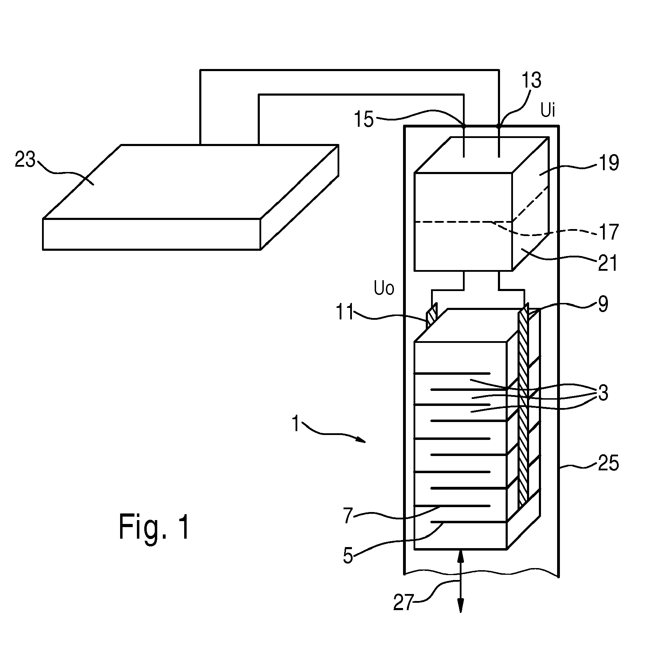

In Figur 1 ist ein piezoelektrischer Aktor in seiner Gesamtheit mit dem Bezugszeichen 1 versehen. Der piezoelektrischen Aktor 1 besteht aus einer Vielzahl von übereinander angeordneten Keramikschichten 3, die einen sogenannten Multilayerstapel bilden. Zwischen den piezoelektrischen Keramikschichten 3, von denen aus Gründen der Übersichtlichkeit nicht alle mit Bezugszeichen versehen, sind Elektrodenschichten 5 und 7 angeordnet. Auch hier sind aus Gründen der Übersichtlichkeit nicht alle Elektrodenschichten 5 und 7 mit Bezugszeichen versehen worden.

Die mit dem Bezugszeichen 5 versehenen Elektrodenschichten bilden eine erste Gruppe und sind mit einer ersten Außenelektrode 9 elektrisch verbunden. Die mit dem Bezugszeichen 7 versehenen Elektrodenschichten bilden eine zweite Gruppe und sind mit einer zweiten Außenelektrode 11, die wegen der isometrischen Darstellung der Figur 1 nur teilweise sichtbar ist, elektrisch verbunden.

Der piezoelektrische Aktor 1 umfasst einen ersten elektrischen Anschluss 13 und einen zweiten elektrischen Anschluss 15. Der erste Anschluss 13 ist mit der ersten Außenelektrode 9 elektrisch verbunden, während der zweite Anschluss 15 mit der zweiten Außenelektrode 11 elektrisch verbunden ist.

Zwischen den Anschlüssen 13 und 15 einerseits sowie den Außenelektroden 9 und 11 andererseits ist ein erfindungsgemäßer piezoelektrischer Transformator 17 angeordnet. Dieser piezoelektrische Transformator 17 basiert auf der Nutzung der piezoelektrischen Effekte. Der piezoelektrische Transformator 17 umfasst einen Eingangsteil 19 und einen Ausgangsteil 21.

Wenn der Eingangsteil 19 durch eine elektrische Eingangsspannung Uᵢ angeregt wird, dehnt sich der Eingangsteil 19 entsprechend der angelegten Eingangsspannung Uᵢ aus oder zieht sich zusammen. Wegen der mechanischen Kopplung von Eingangsteil 19 und Ausgangsteil 21 führt die Längenänderung des Eingangsteils 19 zu einer Längenänderung des Ausgangsteils 21. Infolge des sogenannten direkten piezoelektrischen Effekts wird dadurch durch die Dehnung des Ausgangsteils 21 eine Ausgangsspannung Uₒ erzeugt.

Durch die geeignete Abstimmung und Dimensionierung des Eingangsteils 19 und des Ausgangsteils 21 wird erreicht, dass die Ausgangsspannung Uₒ höher ist als die Eingangsspannung Ui. Übersetzungsverhältnisse i = Uₒ / Uᵢ von > 5 sind technisch heutzutage möglich.

Im Ergebnis führt das Vorhandensein des piezoelektrischen Transformators 17 dazu, dass bspw. bei einer Eingangsspannung Uᵢ von 200 Volt eine Ausgangsspannung U₀, mit der der eigentliche piezoelektrische Aktor 1 beaufschlagt wird, um den Faktor 10 vergrößert wird.

Dies bedeutet, dass es möglich ist mit einem herkömmlichen Steuergerät 21, das üblicherweise Steuerspannungen von bis zu 200 Volt bereitstellen kann, ist, an den Außenelektroden 9 und 11 des piezoelektrischen Aktors 1 eine Spannung von bis zu 2000 Volt bereitzustellen. Diese hohe elektrische Spannung ermöglicht es, die Dicke der Keramikschichten 3 zu erhöhen und somit bei gleicher Höhe eines Stapels von Keramikschichten die Zahl der Keramikschichten 3 zu reduzieren. Dadurch ergeben sich erhebliche Kosteneinsparungen sowohl bei der Herstellung als auch bei den Materialien für die Elektrodenschichten 5 und 7. Außerdem ist ein piezoelektrischen Aktor 1 mit dickeren keramischen Schichten 3 mechanisch robuster als ein vergleichbarer piezoelektrischen Aktors mit Schichten, deren Dicke unter 100 µm liegen.

Es versteht sich von selbst, dass das Steuergerät 23, der piezoelektrische Transformator 17 und der piezoelektrischen Aktor 1 in ihren Eigenschaften, insbesondere auch hinsichtlich ihrer dynamischen Eigenschaften, aufeinander abgestimmt werden müssen, um ein optimales Betriebsverhalten des erfindungsgemäßen piezoelektrischen Aktors 1 zu erreichen.

Der erfindungsgemäße piezoelektrische Aktor 1 und der zugehörige erfindungsgemäße piezoelektrische Transformator 17 sind in einen gemeinsamen Gehäuse 25 zusammengefasst. Das Gehäuse 25 ist in Figur 1 unten offen dargestellt, da eine Stellbewegung des piezoelektrischen Aktors 1 auf ein nichtdargestelltes Stellglied übertragen werden muss. Die Stellbewegung des piezoelektrischen Aktors 1 ist in Figur 1 durch einen Doppelpfeil 27 angedeutet.

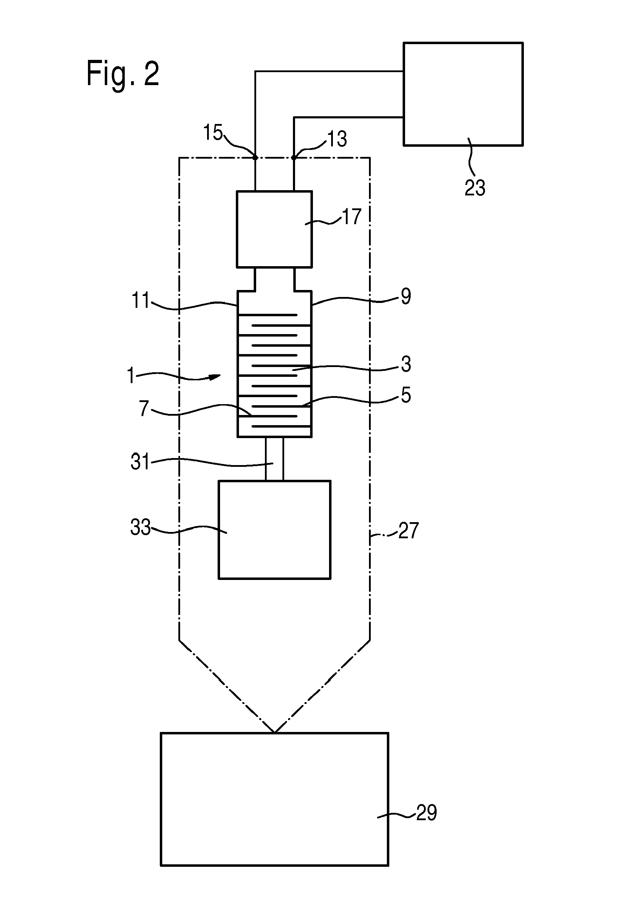

Die erfindungsgemäße Anordnung von piezoelektrischem Transformator 17 und piezoelektrischen Aktor 1 in einer Einheit kann bei vielen Anwendungen erfolgreich eingesetzt werden. Besonders bevorzugte Anwendungen sind der Einsatz in Ventilen, wie sie bspw. in Fahrsicherheitssystemen, wie ABS, ASR und anderem mehr eingesetzt werden. Eine weitere sehr wichtige Anwendung der erfindungsgemäßen Anordnung wird nachfolgend anhand der Figur 2 erläutert. Gleiche Bauteile werden mit den gleichen Bezugszeichen versehen und es gilt das bezüglich Figur 1 gesagt entsprechend.

In Figur 2 trägt eine Kraftstoffeinspritzvorrichtung insgesamt das Bezugszeichen 27. Sie ist nur schematisch und punktiert dargestellt und kommt in einer Brennkraftmaschine (nicht dargestellt) zu Einsatz. Die Kraftstoffeinspritzvorrichtung 27 dient zur Einspritzung von Kraftstoff in einen Brennraum 29 der Brennkraftmaschine. Die Kraftstoffeinspritzvorrichtung 27 umfasst einen piezoelektrischen Aktor 1 und einen piezoelektrischen Transformator 17. Der piezoelektrische Aktor 1 ist über eine Kopplungseinrichtung 31 mit einem nur symbolisch dargestellten Ventilelement 33 verbunden.

Über den piezoelektrischen Transformator 17 ist der piezoelektrische Aktor 1 mit einem Steuergerät 23 verbunden. Durch Anlegen einer Spannung Uᵢ an den elektrischen Anschlüssen 13 und 15 wird der piezoelektrischen Transformator 17 aktiviert und stellt an der ersten Außenelektrode 9 und der zweiten Außenelektrode 11 des piezoelektrischen Aktors 1 eine gegenüber der Eingangsspannung Uᵢ deutlich erhöhte Ausgangsspannung Uₒ zur Verfügung. Die Ausgangspannung Uₒ verändert die elektrisch Ladung des piezoelektrischen Aktors 1 und in Folge dessen ändert sich die Länge des piezoelektrischen Aktors 1. Diese Längenänderung wird über die Kopplungseinrichtung 31 auf das Ventilelement 33 übertragen und ermöglicht dadurch in an sich bekannter Weise das Öffnen und Schließen der Kraftstoffeinspritzvorrichtung.

## Patentansprüche

1. Piezoelektrischer Aktor mit mehreren übereinander angeordneten Keramikschichten (3), mit einem ersten elektrischen Anschluss (13) und mit einem zweiten elektrischen Anschluss (15), wobei zwischen den Keramikschichten (3) jeweils eine Elektrodenschicht (5, 7) vorgesehen ist, wobei eine erste Gruppe von Elektrodenschichten (5) elektrisch mit dem ersten Anschluss (13) verbunden ist, und wobei einer zweite Gruppe von Elektrodenschichten (7) elektrisch mit dem zweiten Anschluss (15) verbunden ist, **dadurch gekennzeichnet, dass** zwischen erstem elektrischen Anschluss (13) und zweitem elektrischen Anschluss (15) einerseits und den Elektrodenschichten (5, 7) andererseits ein piezoelektrischer Transformator (17) vorgesehen ist.

2. Piezoelektrischer Aktor nach Anspruch 1, **dadurch gekennzeichnet, dass** der piezoelektrische Transformator (17) eine elektrische Eingangsspannung (Uᵢ) mit einem Übersetzungsverhältnis (i) größer 5, bevorzugt größer 8, und besonders bevorzugt etwa gleich 10, in eine elektrische Ausgangsspannung (Uₒ) übersetzt.

3. Piezoelektrischer Aktor nach einem der vorhergehenden Ansprüche, **dadurch gekennzeichnet, dass** die erste Gruppe von Elektrodenschichten (5) mit einer ersten Außenelektrode (9) elektrisch verbunden sind, dass die zweite Gruppe von Elektrodenschichten (7) mit einer zweiten Außenelektrode (11) elektrisch verbunden sind, und dass die erste Außenelektrode (9) und die zweite Außenelektrode (11) elektrisch mit dem piezoelektrischen Transformator (17) verbunden sind.

4. Piezoelektrischer Aktor nach einem der vorhergehenden Ansprüche, **dadurch gekennzeichnet, dass** der erste Anschluss (13) und der zweite Anschluss (15) mit dem piezoelektrischen Transformator (17) elektrisch verbunden sind.

5. Piezoelektrischer Aktor nach einem der vorhergehenden Ansprüche, **dadurch gekennzeichnet, dass** der erste Anschluss (13) und der zweite Anschluss (15) von einem Steuergerät (23) angesteuert werden.

6. Piezoelektrischer Aktor nach einem der vorhergehenden Ansprüche, **dadurch gekennzeichnet, dass** der piezoelektrische Aktor (1) und der piezoelektrische Transformator (17) in einem Gehäuse (25) angeordnet sind.

7. Piezoelektrischer Aktor nach einem der vorhergehenden Ansprüche, **dadurch gekennzeichnet, dass** die Keramikschichten (3) des piezoelektrischen Aktors (1) dicker als 600 µm, bevorzugt dicker als 800 µm und besonders bevorzugt etwa 1000 µm dick sind.

8. Piezoelektrischer Aktor nach einem der vorhergehenden Ansprüche, **dadurch gekennzeichnet, dass** die Eingangsspannung (Uᵢ) des piezoelektrischen Transformators () größer als 100 V und bevorzugt etwa gleich 200 V ist.

9. Piezoelektrischer Aktor nach einem der vorhergehenden Ansprüche, **dadurch gekennzeichnet, dass** der piezoelektrische Aktor (1) und der piezoelektrische Transformator (17) in eine Kraftstoff-Einspritzvorrichtung (27), insbesondere einen Injektor, für eine Brennkraftmaschine integriert sind.

10. Piezoelektrischer Aktor nach einem der Ansprüche 1 bis 8, **dadurch gekennzeichnet, dass** der piezoelektrische Aktor (1) und der piezoelektrische Transformator (17) in ein elektrisch betätigtes Ventil, insbesondere ein Druckregelventil für ein Anti-Blockier-System (ABS) eines Fahrzeugs, integriert sind.
